(19) Europäisches Patentamt
European Patent Office
Office européen des brevets

(11) Publication number: 0 164 270 B1

# (12) EUROPEAN PATENT SPECIFICATION

(45) Date of publication of patent specification: 02.05.90

(51) Int. Cl.[5]: G 03 F 7/033

(21) Application number: 85304044.2

(22) Date of filing: 07.06.85

## (54) Photo-polymerizable compositon and printing plate prepared therefrom.

(30) Priority: 08.06.84 US 618483
05.10.84 US 658150

(43) Date of publication of application:
11.12.85 Bulletin 85/50

(45) Publication of the grant of the patent:
02.05.90 Bulletin 90/18

(84) Designated Contracting States:
AT BE CH DE FR GB IT LI LU NL SE

(56) References cited:
DE-A-2 816 774
FR-A-2 255 632
FR-A-2 350 625
GB-A-1 376 450

(73) Proprietor: NAPP SYSTEMS INC.
360 South Pacific Avenue
San Marcos California 92069 (US)

(72) Inventor: Ishikawa, Katsukiyo
14-19 Sennichi-Cho
Yamatakohriyama City Nara (JP)
Inventor: Konishi, Katsuji
4472 Honmachi
Izumisano City Osaka (JP)
Inventor: Kusuda, Hidefumi
1-13 Higashi-Funabashi
Hirakata City Osaka (JP)

(74) Representative: Votier, Sidney David et al
CARPMAELS & RANSFORD 43, Bloomsbury
Square
London WC1A 2RA (GB)

The file contains technical information submitted after the application was filed and not included in this specification

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

EP 0 164 270 B1

Courier Press, Leamington Spa, England.

**Description**

This invention relates to a photo-polymerizable or photo-sensitive resin composition for the manufacture of printing plates, especially relief printing plates. The invention is particularly directed to a photo-polymerizable composition suitable for preparing printing plates having high resistance to water-based inks and yet capable of being developed by water.

Background of the Invention

In the preparation of relief printing plates, particularly those intended for use in flexographic printing in the newspaper industry, it is very desirable, due in part to the nature of the environment in a pressroom, to be able to utilize water-based inks, since oil-based inks tend to mist and hence to contribute to health problems and other objectionable environmental considerations. Moreover, the use of a water-based ink is highly desirable since the resulting print will not show through the newspaper from one side to the other and does not tend to rub off on the hands of the reader.

In addition to the foregoing, it is also highly desirable to have a photo-polymerizable composition which may be developed utilizing water, rather than organic solvents. The use of such solvent-based developing solutions is highly undesirable, due to the same workplace and environmental considerations referred to above. Moreover, the use of organic solvents as the developing medium renders the developing process considerably more complex, because preparation of the devloping chemical solution is complicated and gives rise to a host of serious problems. In contrast, photo-polymerizable compositions which may be developed with water are capable of avoiding troublesome preparation problems and also eliminate the danger of mistaken preparation, as well as the workplace and environmental problems referred to previously.

Prior to the present invention, several attempts have been made to provide a satisfactory photo-polymerizable composition for relief printing. Thus, such compositions are known which utilize a liquid unsaturated polyester base, a polyvinyl alcohol base, a water-soluble nylon base, a cellulose acetate succinate base, and an alcohol-soluble nylon base. All such materials, however, suffer from significant disadvantages. The liquid polyester base is inconvenient to handle because it is liquid and further has the significant defect of necessitating the use of an alkaline solution or a special air knife for developing. The polyvinyl alcohol base materials and the water-soluble nylon base materials, while capable of being developed with water, have extremely low resistance to water and consequently are not suitable for use with water-based inks. The cellulose acetate succinate base material requires the use of an alkaline solution to develop, and the alcohol-soluble nylon base requires the use of an inflammable alcohol solution for development, which is highly undesirable.

In United States Patent No: 3,801,328, a water developable photo-polymerizable composition is described utilizing unsaturated ethylenic monomers, a photo-polymerization initiator and a partially saponified polyvinyl acetate. That composition has been found to work very satisfactorily to produce water-developable printing plates. However, the water resistance of the resulting plate surface is low, which in turn precludes its effective use with a water-based ink.

In light of the foregoing, it is clearly highly desirable to have a water-developable photo-polymerizable composition which is satisfactory for the preparation of relief printing plates and sufficiently water-resistant to be suitable for use with water-based inks. The present invention thus addresses that need.

Summary of the Invention

The present invention is a water-developable, photo-polymerizable composition for use in the preparation of relief printing plates, which upon curing is resistant to water and is capable of use with water-based inks, comprising

(A) a copolymer of 5 to 40 mol% of an α,β-ethylenically unsaturated carboxylic acid, at least 5 mol% of a vinyl monomer selected from the group consisting of styrene α-methyl styrene, vinyl toluene, acrylonitrile, vinyl chloride, vinylidene chloride, (meth)acrylamide, (meth)acrylic esters and combinations thereof, and 10 to 70 mol% of an aliphatic conjugated diene, said copolymer having an average molecular weight of approximately 5,000 to about 300,000,

(B) a monomeric vinyl compound having a secondary or tertiary nitrogen atom to neutralise carboxylic groups in said copolymer (A),

(C) a non-gaseous ethylenically unsaturated monomeric compound having at least one terminal ethylenic double bond, and

(D) a photoinitiator,

the amounts of the copolymer (A), the non-gaseous ethylenically unsaturated monomeric compound (C) and the photoinitiator (D) being respectively from about 30 to 90% by weight, from about 5 to 65% by weight and from about 0.01 to 10.0% by weight, based on the total weight of the composition, and the amount of the vinyl compound (B) being sufficient to neutralize from 20 to 100% of the carboxylic groups in copolymer (A).

By using this composition, plates having resistance against water-based inks may be prepared, which plates may be developed with water.

With the photosensitive resin composition, not only water but also alkaline solutions such as diluted alkali hydroxide solutions and organic solvents can be used for developing.

The copolymerized resin (A) used in this invention is made by copolymerizing an α,β-ethylenically unsaturated carboxylic acid (5—40 mol%, preferably 10—30 mol%), a carboxylic acid (5—40 mol%, preferably 10—30 mol%), a vinyl monomer (at least 5 mol%, preferably 20—40 mol%), and an aliphatic conjugated diene (10—70 mol%, preferably 10—60 mol%), and has an average molecular weight in the range 5,000—300,000, preferably 10,000—250,000.

The α,β-ethylenically unsaturated carboxylic acid in the copolymerized resin (A) can for example be acrylic acid, methacrylic acid, maleic acid, fumaric acid, citraconic acid, etc., and these can be used alone or in combination. The vinyl monomer in resin (A) is α-methylstyrene, vinyltoluene, acrylonitrile, vinyl chloride, vinylidene chloride, (meth)acrylamide, or a (meth)acrylic ester, alone or in combination. Suitable (meth)acrylic esters include methyl (meth)acrylate, ethyl (meth)acrylate, propyl (meth)acrylate, and n-butyl (meth)acrylate. The aliphatic conjugated diene can be butadiene, isoprene, dimethylbutadiene, chloroprene, etc. They can be used alone or in combination.

As for the vinyl compound (B) having a secondary or tertiary nitrogen, styrene family monomers having the following general formula are suitable:

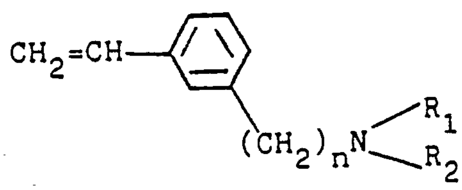

(1)

In formula (1), n is a number 1 to 3, and $R_1$ and $R_2$ are hydrogen or a $C_1$—$C_4$ alkyl group; provided, however, that when $R_1$ is H, $R_2$ is alkyl and when $R_2$ is H, $R_1$ is alkyl. Examples of such styrene monomers are dimethylaminomethylstyrene and diethylaminoethylstyrene. Pyridine family monomers may also be used, such as vinylpyridine, methylvinylpyridine and ethylvinylpyridine, as may (meth)acrylic monomers having the following general formulae

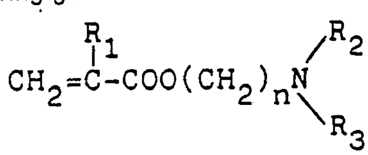 (2) 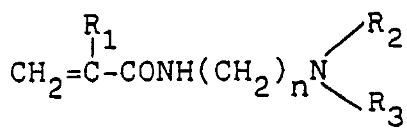 (3)

In the above formulae (2) and (3), n is a number 1 to 4; $R_1$ is a hydrogen atom or methyl; and $R_2$ and $R_3$ are hydrogen or a $C_1$~$C_4$ alkyl group, an alkylol or an alkoxy group, provided, however, that when $R_2$ is H, $R_3$ is alkyl, alkylol or alkoxy and when $R_3$ is H, $R_2$ is alkyl, alkylol or alkoxy. Examples are N,N-dimethylaminoethyl (meth)acrylate, N,N-diethylamino ethyl (meth)acrylate, N,N-dibutylaminoethyl (meth)acrylate, N,N-dimethylaminopropyl (meth)acrylate N,N-diethylaminopropyl (meth)acrylate, N,N-dimethylaminobutyl (meth)acrylate, etc., N,N-dimethylaminoethyl (meth)acrylmide, N,N-diethylaminopropyl (meth)acrylamide and N-methylolethyl (meth)acrylmide. They can be used alone or in combination. It is preferable to use a vinyl compound having a nitrogen atom with a lone pair of electrons which are not conjugated to double bonds.

The non-gaseous ethylenically-unsaturated compound having at least one terminal ethylenic double bond preferably has affinity with the above-described copolymerized resin (A). For example, carboxylic acid esters such as ethyleneglycol di(meth)acrylate, diethyleneglycol di(meth)acrylate, triethyleneglycol di(meth)acrylate, tetramethyleneglycol di(meth)acrylate, diaryl itaconate, glycerine di(meth)acrylate, glycerine tri(meth)acrylate, 1,3-propyleneglycol di(meth)acrylate, 1,4-cyclohexandediol di(meth)acrylate, 1,2,4-butanetriol tri(meth)acrylate, 1,4-benzenediol di(meth)acrylate, pentaerythritol tetra(meth)acrylate, 1,5-pentanediol di(meth)acrylate, 1,6-hexanedio di(meth)acrylate, etc., may be used as well as unsaturated amides such as methylene bis(meth)acrylamide, ethylene bis(meth)acrylamide, 1,6-hexamethylene bisacrylamide, diethylenetriamin trismethacrylamide, 4-(β-hydroxyethyl) methacrylamide, N,N-bis(β-hydroxyethyl)acrylamide, divinyl esters such as divinyl adipate, divinyl phthalate (meth)acrylated urethane derived from hydroxyalkyl (meth)acrylate and isocyanate compounds, di(meth)acrylate of diepoxypolyether derived from aromatic compounds with poly alcohols such as bisphenol or Novolac compound. These can be used singly or in mixtures of two or more kinds, but a water-insoluble compound is desirable.

As for the photoinitiator (D) used in this invention, benzoin ethers such as benzoin isopropylether, benzoin isobutylether, benzophenones such as benzophenone, o-benzoyl methylbenzoate, xanthones such as xanthone, thio-xanthone, 2-chlorothioxanthone, 2-isopropylthioxanthone, acetophenones such as acetophenone, trichloroacetophenone, 2,2-diethoxyacetophenone, 2,2-dimethoxy-2-phenylacetophenone, and others such as benzil, 2-ethylanthraquinone, methylbenzoylformate, 2-hydroxy-2-methylpropyophenone, 2-hydroxyl-4-isopropyl-2-methyl propyophenone, and 1-hydroxy-cyclohexylphenyl-ketone, are suitable. They can be used alone or in combination.

The photosensitive resin composition of the present invention comprises essential ingredients in the following proportions: co-polymerized resin (A) — 30—90 weight percentage, preferably 40—80 weight percentage; vinyl monomer (B) — having a secondary or a tertiary nitrogen atom — an amount sufficient to neutralize 20—100% of the carboxyl groups of the copolymerized resin (A); unsaturated compound (C) — 5—65 weight percentage, preferably 15—55 weight percentage; and photosensitizer (D) — 0.01—10.00 weight percentage, preferably 0.05—5.00 weight percentage. Furthermore, it is possible to add to this composition, as desired or necessary, known polymerization inhibitors such as hydroquinone, mono*tert*-butylhydroquinone, catechol, *tert*butylcatechol, benzoquinone, 2,5-diphenyl-p-benzoquinone, phenothiazine, dyes such as esosin Y, rose-bengal, and other additives and plasticizers which can dissolve into copolymerized resin (A) such as dialkyl phthalates, dialkyl fumarates, dialkyl sebacates, dialkyl itaconates, alkyl phosphates, polyethyleneglycol, polyethyleneglycol esters, polyethyleneglycol ethers, etc.

The photosensitive resin composition of the present invention is formed into an even layer of 0.01—10.00 mm by extrusion or by calendering. It is exposed to a light through an appropriate negative film. The polymerization process of the exposed area occurs, creating a polymerized image which is not soluble by water, alkali solution, or organic solvent. Once the unpolymerized part of the unexposed area is removed by using water, a relief printing plate is obtained which has high resistance against water-based inks.

The invention will now be explained by reference to experimental examples. In the Examples, "parts" and "%" are by weight.

Experimental Example 1

A photosensitive resin composition made of 50 weight parts of a co-polymerized resin ($\overline{M}w$ = 50,000) composed of ethylacrylate (60 mol%), methacrylic acid (15 mol%), and butadiene (25 mol%) 3 weight parts of dimethylaminoethylacrylate, an ethylenically unsaturated monomer compound, 1.5 weight part of 2,2-dimethoxy-2-phenylacetophenone, and 0.15 weight part of 2,6-ditertbutylcatechol was moulded into a plate of about 0.5 mm thickness on a steel plate of 0.18 m thickness by calendering at about 80°C.

Onto the surface of the resin composition thus obtained, a negative film containing lines and half-tones was contacted tightly by a vacuum. the plate was exposed to a chemical lap of 350W for one minute from a distance of 6 cm. The negative was then removed, and the unexposed area was washed away by water using a Nylon brush at 40°C. A relief image was thus obtained on the negative film. The relief plate obtained by the above-mentioned method was put on a so-called "stack type flexo press". The plate was printed on kraft paper using water-based ink at the speed of 50 meter/minute. the print showed a sharp image without any sign of deterioration during two hours of press running.

Comparison Example 1

A negative film containing lines and half-tones was contacted closely to a NAPP plate of an overall thickness of 0.57 mm having as a major binder partially saponified polyvinylacetate (degree of polymerization = 500, degree of saponification = 87.5 mol%). It was exposed to light for 40 seconds under a high pressure mercury-vapor lamp of 3KW and was then washed by water for one minute and forty seconds using a spray type machine at water temperature 40°C and at water pressure of 6 $kg/cm^2$. It was dried for two minutes at 100°C with a high pressure mercury-vapor lamp of 2 KW.

The relief plate obtained by the above-mentioned method was used in printing, using water-based ink (Sun Chemical Corp.) on a kraft paper with a stack-type flexographic printing machine. After 2 minutes with a speed of 50 m/minute, the surface of the relief became swollen by water, and it was not possible to obtain a sharp image.

Experimental Example 2

A mixture of 70 weight parts of co-polymerized resin ($\overline{M}w$ = 50,000) composed of ethylacrylate (65 mol%), methacrylic acid (10 mol%) an butadiene (25 mol%), 5 weight parts of dimethylaminopropylacrylamide, 15 weight part of phenoxyethylacrylate, 3 weight parts of 1,4-butanedioldiacrylate, 1.5 weight parts of 2,2-dimethoxy-2-phenylacetophenone, and 0.5 weight parts of phenothiazine was kneaded well at the temperature of 40°C.

The kneaded material was made into a photosensitive composition sheet of 2 mm thickness by the same method used in Experimental Example 1.

A negative film containing lines and half-tones was contacted closely to this sheet, and it was exposed to light for five minutes from a distance of 6 cm under a chemical lamp of 350W. The negative film was then removed, and the sheet was washed by water using an oscillating brush type machine for four minutes at the water temperature of 40°C. Then it was dried in a drying oven for 2 minutes at 110°C using a high pressure mercury-vapor lamp of 2KW. The relief image obtained through the above-described method had an elasticity, Shore A hardness of 70° and high water resistance, characteristics suitable for flexo press.

This was tried in printing over a kraft paper using a stack-type flexographic printing machine. The surface of the relief was not affected after 4 hours with a speed of 200 m/minute. Also, the printing image was faithful to the original and was sharp.

Comparison Example 2

A mixture of 80 weight parts of water-soluble polyamide resin whose 52 mol% of hydrogen atoms at the α-position of poly ε-caproamide (Nylon 6) were substituted by dimethylamino base 52 mol%, 9 weight parts of tetraethyleneglycol, 6 weight parts of acrylamide, 2 weight parts of N,N-methylenebisacrylamide, 2.5 weight parts of benzoin isobutylether, 0.4 weight parts of 2,6-di-tert-butylcatechol, and 0.1 weight parts of p-methoxyphenol was mixed in a pressurized kneader at normal temperature. It was extruded in a rod-like form and pressed by a calender over a colored steel plate having a thickness of 0.3 mm. Thus, a photosensitive composition sheet of an overall thickness of 0.96 mm was obtained.

This was processed by the same method used in Experimental Example 2, and a relief image of 0.66 mm with a Shore A hardness 96 was obtained. Thus was cut into test pieces of 2.5 cm × 5.0 cm, an the pieces were then immersed in 94 weight % of plain water and 1 weight % of $Na_2CO_3$ and butylcellosolve 5 weight % at a temperature of 40°C for 2 hours. The relief surface of each strip became swollen by liquid by more than 20% of the total thickness.

Experimental Example 3

A mixture of 80 weight parts of co-polymerized resin ($\overline{M}w$ = 75,000) composed of butylacrylate (50 mol%), acrylic acid (15 mol%), butadiene (25 mol%), and dicyclopentenylacrylate (10 mol%), 5 weight parts of dimethylaminoethylacrylate, 0.8 parts of 2,6-di-tert-butylcatechol, 3 weight parts of benzoin isopropylether, and 0.2 weight parts of p-methoxyphenol was mixed in a kneader at room temperature. It was made into a laminate of 0.93 mm total thickness on a polyethylene terphthalate film of 0.13 mm at the temperature of about 60°C.

When processed by the same method used in Experimental Example 2, it showed Shore A hardness 70°. In the immersion test noted in Comparison Example 2, the swelling of the relief was below 2%.

Experimental Example 4

A mixture of 50 weight parts of co-polymerized resin ($\overline{M}w$ = 120,000) composed of ethylacrylate (40 mol%), methacrylic acid (15 mol%), 1,4-butadiene (40 mol%), and dicyclopentenylacrylate (5 mol%), 6 weight parts of dimethylaminopropylacrylamide, 10 weight parts of phenoxy ethylacrylate, 7 weight parts of tripropylene-glycoldiacrylate, 1,2 weight parts of 2,2-dimethoxy-2-phenylacetophenone, 0.7 weight parts of 2,6-di-tert-butylcatechol, and 0.1 weight parts of p-methoxyphenol, was mixed and kneaded for ten minutes in a pressurized kneader at the temperature of 40°C. It was made into a sheet of 0.55 mm thickness by an extruder mold with a T-die. It was laminated over a steel plate of 0.18 mm thickness which was painted with acrylic resin emulsion having 5 mol% carboxyl groups.

To this photosensitive resin composition noted above, a negative film having lines and half-tones was contacted closely by a vacuum. It was exposed to light for 40 seconds by a high pressure mercury-vapor lamp of 3KW, washed with water for 2 minutes at the water temperature of 40°C using an oscillating brush machine and was dried for 2 minutes at a temperature of 110°C in a drying oven with a high pressure mercury-vapor lamp of 2KW.

The relief image obtained by the above-described method had superior elasticity, with Shore A hardness of 55°. 50,000 copies of envelopes having lines and letters were obtained by a stack-type flexographic printing machine at a speed of 180 m/minute. The surface of the relief was not affected at all by water-based ink nor by paper, and the prints were very sharp and bright.

Experimental Example 5

A mixture of 50 weight parts of a co-polymerized resin ($\overline{M}w$ = 110,000) composed of ethyl acrylate (55 mol%), methacrylic acid (20 mol%), butadiene (25 mol%), 10 weight parts of N-methylolacrylamide, 25 weight parts of phenoxyethyl acrylate, 2 weight parts of trimethylolpropanetrimethacrylate, 2 weight parts of 2,2-dimethoxy-2-phenylacetophone, 0.90 weight parts of phenothiazine, and 0.1 weight part of p-methoxyphenol, was mixed for ten minutes in a pressurized kneader at the temperature of 40°C. It was made into a sheet of 1.63 mm thickness by an extruder with a T-die, and using the same method described in Experimental Example 4, it was laminated and processed.

The resulting sheet was immersed in water solution containing 1 weight % of $Na_2CO_3$ and 5 weight % of butylcellosolve. 15% swelling was observed.

Experimental Example 6

A mixture of 70 weight parts of a co-polymerized resin ($\overline{M}w$ = 80,000) composed of ethylacrylate (30 mol%), 2-hydroxyethylacrylate (5 mol%), methacrylic acid (15 mol%), 1,4-butadiene (40 mol%), and dicyclopentenylacrylate (10 mol%), 8 weight parts of dimethylaminopropylmethacrylamide, 12 weight parts of diethyleneglycolmonophenylether acrylate, 4 weight parts of tetraethyleneglycoldimethacrylate, 4 weight parts of propyleneglycoldi-2-hydroxyethylacrylate, 1.5 weight parts of benzoin isopropylether, and 0.5 weight parts 2,6-di-tert-butyl-catechol was mixed to obtain a relief plate of 0.57mm in thickness using the same method described in Experimental Example 5. This had a Shore hardness of 75°, and the relief image had superior water and alkali resistance.

The performance results of the Experimental Examples and Comparison Examples are summarized as follows.

| Check Items / Example Number | Relief (mm) | Shore A hardness (2mm thick) | 40°C 2 hours immersion test: water | 40°C 2 hours immersion test: alkali*1 | Minimum high light dot: 65LPI 5% | Minimum high light dot: 85LPI 5% | Independent Line Width (microns) | 65LPI 90% dot depth (microns) |
|---|---|---|---|---|---|---|---|---|
| Exper. Ex. 1 | 0.5 | 97° | S | S | O | O | 30 | 25 |
| Comp. Ex. 1 | 0.4 | 97° | U | U | O | O | 40 | 28 |
| Exper. Ex. 2 | 2.0 | 70° | S | S | △ | △ | 100 | 55 |
| Comp. Ex. 2 | 0.66 | 96° | F | U | O | O | 40 | 38 |
| Exper. Ex. 3 | 0.8 | 70° | S | S | O | O | 60 | 32 |
| Exper. Ex. 4 | 0.55 | 55° | S | S | O | O | 40 | 35 |
| Exper. Ex. 5 | 1.63 | 75° | S | F | O | △ | 80 | 40 |
| Exper. Ex. 6 | 0.57 | 82° | S | S | O | O | 40 | 32 |

*1 = water solution containing 1 weight % of $Na_2CO_3$, 5 weight % of butylcellosolve
S = swelling ratio thickness of relief below 5%
F = swelling ratio thickness of relief 5%—20%
U = swelling ratio thickness of relief over 20%
O = 100% highlight dots retained (visual examination)
△ = 90% highlight dots retained (visual examination)

It will thus be appreciated from the foregoing, especially the illustrative examples, that the photopolymerizable composition of the present invention produces printing plates that not only are developable with water but also are quite water resistant and capable of use with water-based inks.

While the invention has been described primarily with respect to relief printing plates, it should be recognized that it may also be used to make plates for offset printing or for screen printing. By the same token, while specific embodiments of the invention have been disclosed, it should be understood that modifications and equivalents of such embodiments, as will be apparent to those skilled in the art, are to be within the scope of the invention.

**Claims**

1. A water-developable, photopolymerizable composition for use in the preparation of relief printing

plates, which upon curing is resistant to water and is capable of use with water-based inks, comprising

(A) a copolymer of 5 to 40 mol% of an α,β-ethylenically unsaturated carboxylic acid, at least 5 mol% of a vinyl monomer selected from the group consisting of styrene α-methyl styrene, α-methyl styrene, vinyl toluene, acrylonitrile, vinyl chloride, vinylidene chloride, (meth)acrylamide, (meth)acrylic esters and combinations thereof, and 10 to 70 mol% of an aliphatic conjugated diene, said copolymer having an average molecular weight of approximately 5,000 to about 300,000,

(B) a monomeric vinyl compound having a secondary or tertiary nitrogen atom to neutralise carboxylic groups in said copolymer (A),

(C) a non-gaseous ethylenically unsaturated monomeric compound having at least one terminal ethylenic double bond, and

(D) a photoinitiator,

the amounts of the copolymer (A), the non-gaseous ethylenically unsaturated monomeric compound (C) and the photoinitiator (D) being respectively from about 30 to 90% by weight, from about 5 to 65% by weight and from about 0.01 to 10.0% by weight, based on the total weight of the composition, and the amount of the vinyl compound (B) being sufficient to neutralize from 20 to 100% of the carboxylic groups in copolymer (A).

2. A composition according to claim 1 in which said copolymer (A) has an average molecular weight of approximately 10,000 to about 250,000.

3. A composition according to claim 1 or 2 in which said diene is butadiene, isoprene, dimethylbutadiene or chloroprene.

4. A composition according to any of claims 1 to 3 in which said ethylenically unsaturated carboxylic acid is (meth)acrylic acid.

5. A composition according to any of claims 1 to 4 in which said monomeric vinyl compound has a tertiary nitrogen atom with a single pair of electrons, said electrons not conjugated to double bonds.

6. A composition according to any of claims 1 to 5 in which said ethylenically unsaturated monomeric compound is a water-insoluble compound.

7. A composition according to claim 6 in which said unsaturated compound is a carboxylic acid ester.

8. A composition according to claim 7 in which said carboxylic acid ester is ethyleneglycol dimethacrylate, diethyleneglycol di(meth)acrylate, triethyleneglycol di(meth)acrylate, tetramethyleneglycol di(meth)acrylate, diarylitaconate, glycerine di(meth)acrylate, glycerine tri(meth)acrylate, 1,4-cyclohexandediol di(meth)acrylate, 1,2,4-butanetriol tri(meth)acrylate, pentaerythritol tetra(meth)acrylate, 1,5-pentanediol di(meth)acrylate, or 1,6-hexanediol di(meth)acrylate.

9. A composition according to any of claims 1 to 6 in which said nongaseous ethylenically unsaturated compound (C) is an unsaturated amide, a divinyl ester, a (meth)acrylated urethane, an isocyanate compound, or di(meth)acrylate of diepoxypolyether.

10. A composition according to any of claims 1 to 9 in which said photoinitiator is a benzoin ether or an acetophenone derivative.

11. A composition according to any of claims 1 to 10 comprising about 40 to about 80 weight percent of said copolymer (A), about 15 to 55 weight percent of said ethylenically unsaturated monomeric compound (C), and about 0.05 to about 5.0 weight percent of said photoinitiator (D).

12. A composition according to claim 1 in which said monomeric vinyl compound (B) is a styrene monomer having the general formula:

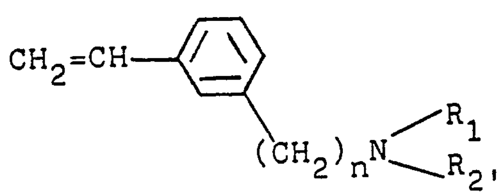

where n is 1 to 3, $R_1$ and $R_2$ are hydrogen or $C_1$—$C_4$ alkyl groups, but provided that when $R_1$ is H, $R_2$ is alkyl and when $R_2$ is H, $R_1$ is alkyl; a pyridine monomer or a (meth) acrylic monomer having the formula:

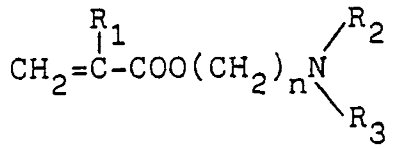 or 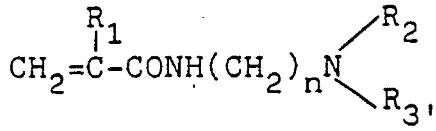

where n is 1 to 4, $R_1$ is hydrogen or methyl or $R_2$ and $R_3$ are hydrogen or $C_1$—$C_4$ alkyl groups, alkyl groups, alkylol or alkoxy groups, but provided that when $R_2$ is H, $R_3$ is alkyl, alkylol or alkoxy and when $R_3$ is H, $R_2$ is alkyl, alkylol or alkoxy.

13. A plate for use as a photopolymer printing plate comprising a support and a coating thereon of the water developable photopolymerizable composition of any of claims 1 to 12.

**Patentansprüche**

1. Wasser-entwickelbare, photopolymerisierbare Zusammensetzung zur Verwendung bei der Herstellung von Relief-Druckplatten, welche Zusammensetzung nach dem Härten wasserresisten und zur Verwendung mit Druckfarben auf Wasserbasis geeignet ist, enthaltend.

(A) ein Copolymer von 5 bis 40 Mol.-% einer α,β-ethylenisch ungesättigten Carbonsäure, mindestens 5 Mol.-% eines Vinylmonomers aus der Gruppe Styrol, α-Methylstyrol, Vinyltoluol, Acrylnitril, Vinylchlorid, Vinylidenchlorid, (Meth)acrylamid, (Meth)acrylester und Kombinationen derselben und 10 bis 70 Mol.-% eines aliphatischen konjugierten Diens, wobei dieses Copolymer ein mittleres Molekulargewicht von etwa 5000 bis etwa 300,000 aufweist,

(B) eine monomere Vinylverbindung mit einem sekundären oder tertiären Stickstoffatom zur Neutralisation der Carboxylgruppen in diesem Copolymer (A),

(C) eine nicht gasförmige ethylenisch ungesättigte monomere Verbindung mit zumindest einer endständigen ethylenischen Doppelbindung und

(D) einen Photoinitiator, wobei die Mengen des Copolymeren (A), der nicht gasförmigen ethylenisch ungesättigten monomeren Verbindung (C) und des Photoinitiators (D) jeweils etwa (30) bis 90 Gew.-%, etwa 5 bis 65 Gew.-% bzw. etwa 0,01 bis 10,0 Gew.-% bezogen auf das Gesamtgewicht der Zusammensetzung betragen und die Menge der Vinylverbindung (B) zur Neutralisation von 20 bis 100% der Carbonsäuregruppen in dem Copolyer (A) ausreicht.

2. Zusammensetzung nach Anspruch 1, in welcher das Copolymer (A) ein mittleres Molekulargewicht von etwa 10,000 bis etwa 250,000 hat.

3. Zusammensetzung nach Anspruch 1 oder 2, in welcher das Dien Butadien, Isopren, Dimethylbutadien oder Chloropren ist.

4. Zusammensetzung nach irgendeinem der Ansprüche 1 bis 3, in welcher die ethylenisch ungesättigte Carbonsäure (Meth)acrylsäure ist.

5. Zusammensetzung nach irgendeinem der Ansprüche 1 bis 4, in welcher die monomere Vinylverbindung ein tertiäres Stickstoffatom mit einem einsamen Elektronenpaar aufweist, dessen Elektronen nich zu Doppelbindungen konjugiert sind.

6. Zusammensetzung nach irgendeinem der Ansprüche 1 bis 5, in welcher die ethylenisch ungesättigte monomere Verbindung eine wasserunlösliche Verbindung ist.

7. Zusammensetzung nach Anspruch 6, in welcher die ungesättigte Verbindung ein Carbonsaüreester ist.

8. Zusammensetzung nach Anspruch 7, in welcher der Carbonsäureester Ethylenglykoldimethyacrylat, Diethylenglykol-di(meth)acrylat, Triethylenglykol-di(meth)acrylat, Tetramethylenglykol-di(meth)acrylat, diarylitaconat, Glyzerin-di(meth)-acrylat, Glyzerin-tri(meth)acrylat, 1,4-Cyclohexandiol-di(meth)acrylat, 1,2,4-Butantriol-tri(meth)acrylat, Pentaerythrol-tetra(meth)acrylat, 1,5-Pentandiol-di(meth)acrylat oder 1,6-Hexandiol-di(meth)acrylat ist.

9. Zusammensetzung nach irgendeinem der Ansprüche 1 bis 6, in welcher die nicht gasförmige ethylenisch ungesättigte Verbindung (C) ein ungesättigtes Amid, ein Divinylester, ein (meth)acryliertes Urethan, eine Isocyanatverbindung oder ein Di(meth)acrylat eines Diepoxypolyethers ist.

10. Zusammensetzung nach irgendeinem der Ansprüche 1 bis 9, in welcher der Photoinitiator ein Benzoinether oder ein Acetophenon-Derivat ist.

11. Zusammensetzung nach irgendeinem der Ansprüche 1 bis 10, enthaltend etwa 40 bis etwa 80 Gew.-% des Copolymeren (A), etwa 15 bis 55 Gew.-% der ethylenisch ungesättigten monomeren Verbindung (C) und etwa 0,05 bis etwa 5,0 Gew.-% des Photoinitiators (D).

12. Zusammensetzung nach Anspruch 1, in welcher die monomere Vinylverbindung (B) ist: ein Styrolmonomer der allgemeinen Formel

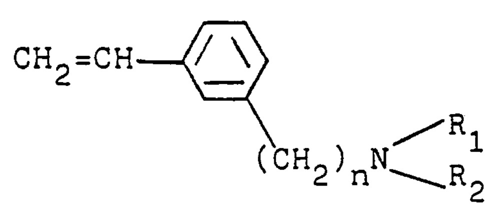

worin n für 1 bis 3, $R_1$ und $R_2$ für Wasserstoff oder $C_1$—$C_4$-Alkylgruppen stehen, mit der Maßgabe, daß, wenn $R_1$ Wasserstoff bedeutet, $R_2$ für Alkyl steht, und, wenn $R_2$ Wasserstoff bedeutet, $R_1$ für Alkyl steht; ein Pyridinmonomer oder ein (meth)acrylisches Monomer der Formel

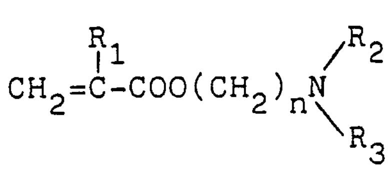

oder

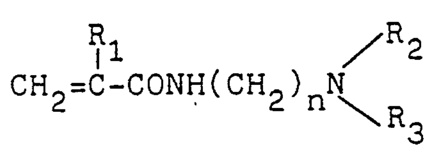

worin n für 1 bis 4, $R_1$ für Wasserstoff oder Methyl und $R_2$ und $R_3$ für Wasserstoff oder $C_1$—$C_4$-Alkygruppen, Alkylol- oder Alkoxygruppen steht, mit der Maßgabe, daß, wenn $R_2$ für Wasserstoff steht, $R_3$ Alkyl, Alkylol oder Alkoxy bedeutet, und, wenn $R_3$ für Wassersoff steht, $R_2$ Alkyl, Alkylol oder Alkoxy bedeutet.

13. Platte zur Verwendung als Photopolymer-Druckplatte mit einem Träger und einer Beschichtung darauf aus der Wasser-entwickelbaren, photopolymerisierbaren Zusammensetzung nach irgendeinem der Ansprüche 1 bis 12.

**Revendications**

1. Composition photopolymérisable, développable à l'eau, destinée à servir à la préparation de plaques d'impression en relief, composition qui, après son durcissement, résiste à l'eau et est capable de servir avec des encres à base d'eau, la composition comprenant:

(A) un copolymère de 5 à 40 moles% d'un acide carboxylique à insaturation éthylénique en alpha-bêta, au moins 5 moles% d'un monomère vinylique choisi dans l'ensemble constitué par le styrène, l'alpha-méthyl-styrène, le vinyl-toluène, l'acrylonitril, le chlorure de vinyl, le chlorure de vinylidène, le (meth)acrylamide, les esters (meth)acryliques et leurs combinations, et 10 à 70 moles% d'un diène conjugué aliphatique, ledit copolymère ayant un poids moléculaire moyen d'environ 5000 à environ 300,000,

(B) un composé vinylique monomère ayant un atome d'azote secondaire ou tertiaire, pour neutraliser les groupes carboxyliques dudit copolymère (A),

(C) un composé monomère à insaturation éthylénique, non gazeux, comportant au moins une double liaison éthylénique terminale, et

(D) un photo-amorceur, les quantités du copolymère (A), du composé monomère (C) à insaturation éthylénique, non gazeux, et du photo-amorceur (D) étant respectivement de 30 à 90% en poids, d'environ 5 à 75% en poids et d'environ 0.01 à 10,0% en poids, sur la base du poids total de la composition, et la quantité du composé vinylique (B) étant suffisante pour neutraliser de 20 à 100% des groupes carboxyliques du copolymère (A).

2. Composition selon la revendication 1, dans laquelle ledit copolymère (A) possède un poids moléculaire moyen d'environ 10,000 à environ 250,000.

3. Composition selon la revendication 1 ou 2, dans laquelle ledit diène est le butadiène, l'isoprène, le diméthylbutadiène ou le chloroprène.

4. Composition selon l'une quelconque des revendications 1 à 3, dans laquelle ledit acide carboxylique à insaturation éthylénique est l'acide (meth)acrylique.

5. Composition selon l'une quelconque des revendications 1 à 4, dans laquelle ledit composé vinylique monomère comporte un atome d'azote tertiaire ayant une seule paire d'électrons, lesdits électrons n'étant pas conjugués à des doubles liaisons.

6. Composition selon l'une quelconque des revendications 1 à 5, dans laquelle ledit composé monomère à insaturation éthylénique est un composé insoluble dans l'eau.

7. Composition selon la revendication 6, dans laquelle ledit composé insaturé est un ester d'acide carboxylique.

8. Composition selon la revendication 7, dans laquelle ledit ester d'acide carboxylique est le diméthacrylate, d'éthylène-glycol, le di(meth)acrylate de diéthylèneglycol, le di(meth)acrylate de triéthylène-glycol, le di(meth)acrylate de tétraméthylène-glycol, un itaconate de diaryle, le di(meth)acrylate de glycérol, le tri(meth)acrylate de glycérol, le di(meth)acrylate de cyclohexane-1,4-diol, le tri(meth)acrylate de butane-1,2,4-triol, le tétra(meth)acrylate de pentaérythritol, le di(meth)acrylate de pentane-1,5-diol, ou le di(meth)acrylate d'hexane-1,6-diol.

9. Composition selon l'une quelconque des revendications 1 à 6, dans laquelle ledit composé (C) à insaturation éthylénique, non gazeux, est un amide insaturé, un ester divinylique, un uréthanne (meth)acrylé, un isocyanate ou un di(meth)acrylate d'un diépoxypolyéther.

10. Composition selon l'une quelconque des revendications 1 à 9, dans laquelle ledit photo-amorceur est un éther de benzoïne ou un dérivé de l'acetophénone.

11. Composition selon l'une quelconque des revendications 1 à 10, comprenant environ 40 à environ 80% en poids dudit copolymère (A), environ 15 à 55% en poids dudit composé monomère (C) à insaturation éthylénique, et environ 0,05 à environ 5,0% en poids dudit photo-amorceur (D).

12. Composition selon la revendication 1, dans laquelle ledit composé vinylique monomère (B) est un monomère de styrène répondant à la formule générale:

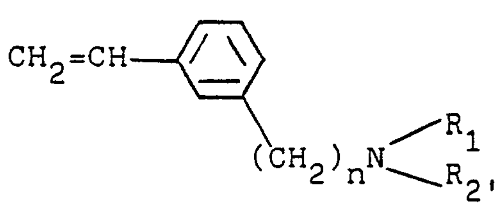

(dans laquelle n vaut 1 à 3; $R_1$ et $R_2$ représentent des atomes d'hydrogène ou des groupes alkyles en $C_1$ à $C_4$, mais à la condition que, lorsque $R_1$ représente un atome d'hydrogène, $R_2$ représente un groupe alkyle et, lorsque $R_2$ représente un atome d'hydrogène, $R_1$ représente un groupe alkyle); un monomère pyridinique et un monomère (meth)acrylique répondant à la formule:

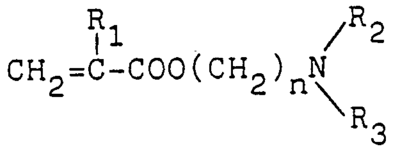

ou

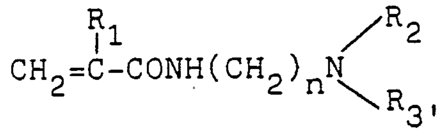

où n vaut 1 à 4, $R_1$ représente un atome d'hydrogène ou un groupe méthyle, et $R_2$ et $R_3$ représentent des atomes d'hydrogène ou des groupes alkyles en $C_1$ à $C_4$, des groupes alkylols ou alcoxy, mais à la condition que, lorsque $R_2$ représente H, $R_3$ représente un group alkyle, alkylol ou alcoxy, et, lorsque $R_3$ représente H, $R_2$ représente un groupe alkyle, alkylol, ou alcoxy.

13. Plaque destinée à servir de plaque photopolymère d'impression, comprenant un support sur lequel se trouve un revêtement constitué par la composition photopolymérisable, développable à l'eau, selon l'une quelconque des revendications 1 à 12.